(19) Europäisches Patentamt / European Patent Office / Office européen des brevets

(11) **EP 4 079 513 A1**

(12) **EUROPEAN PATENT APPLICATION**
published in accordance with Art. 153(4) EPC

(43) Date of publication:
**26.10.2022 Bulletin 2022/43**

(21) Application number: **20901209.5**

(22) Date of filing: **11.12.2020**

(51) International Patent Classification (IPC):
**B32B 9/00** (2006.01)     **C03C 17/34** (2006.01)
**C03C 17/42** (2006.01)

(52) Cooperative Patent Classification (CPC):
**B32B 9/00; C03C 17/34; C03C 17/42**

(86) International application number:
**PCT/JP2020/046418**

(87) International publication number:
**WO 2021/125113 (24.06.2021 Gazette 2021/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **18.12.2019 JP 2019228161**

(71) Applicant: **AGC INC.**
**Chiyoda-ku,**
**Tokyo 1008405 (JP)**

(72) Inventors:
• **NISHIKAWA Yasuhisa**
**Tokyo 100-8405 (JP)**
• **KOBAYASHI Daisuke**
**Tokyo 100-8405 (JP)**

(74) Representative: **Müller-Boré & Partner**
**Patentanwälte PartG mbB**
**Friedenheimer Brücke 21**
**80639 München (DE)**

(54) **TRANSPARENT SUBSTRATE PROVIDED WITH MULTILAYER FILM**

(57)     The present invention pertains to a transparent substrate provided with a multilayer film, the transparent substrate being such that a multilayer film obtained by stacking a metal oxide layer and a silicon oxide layer in the stated order is provided to at least one main surface of a transparent substrate having two main surfaces, Si-Ox in at least one silicon oxide layer within the multilayer film satisfies the relationship $1.55 \leq x < 2.00$, the luminous transmittance of the multilayer film is 20-89%, and the resistance value is $10^4$ $\Omega/\square$ or higher. The x in SiOx is a value derived by depth-direction compositional analysis in X-ray photoelectron spectroscopy (XPS) in which argon ion sputtering is used.

FIG. 1

EP 4 079 513 A1

**Description**

TECHNICAL FIELD

The present invention relates to a transparent substrate provided with a multilayer film.

BACKGROUND ART

In recent years, from the viewpoint of aesthetic appearance, a method of installing a cover glass on a front surface of an image display device such as a liquid crystal display has been used. However, reflection due to the cover glass reflecting external light is one problem, and a multilayer film is often provided on the surface of the cover glass in order to solve such a problem. However, in the multilayer film of related art, a boundary line between a black frame portion of the image display device and an image display portion is conspicuous, and the aesthetic appearance is poor.

Therefore, it is known that the boundary line between the black frame portion of the image display device and the image display portion can be made inconspicuous by imparting light absorption ability to the multilayer film, and further, reflection from an interface between the cover glass and an anti-reflection film can be prevented. For example, Patent Literature 1 discloses a transparent substrate provided with a multilayer film, which has a light absorption ability and an insulating property. Patent Literature 2 discloses a transparent conductive laminate in which a silicon oxide layer and a copper layer are laminated in order.

CITATION LIST

PATENT LITERATURE

> Patent Literature 1: JP-A-2018-115105
> Patent Literature 2: JP-A-2016-068470

SUMMARY OF INVENTION

TECHNICAL PROBLEM

As described above, there has been known a technique of imparting light absorption ability to a multilayer film to provide aesthetic appearance and further prevent reflection from an interface between a cover glass and an anti-reflection film. However, it has not yet been realized to provide a transparent substrate having a light absorption ability and satisfying high adhesiveness between multilayer films. Accordingly, an object of the present invention is to provide a transparent substrate provided with a multilayer film, which has a light absorption ability, an insulating property, and excellent adhesiveness.

SOLUTION TO PROBLEM

The present inventors have found that the above-described problems can be solved by a transparent substrate provided with a multilayer film, including a transparent substrate having two main surfaces, and a multilayer film obtained by laminating a metal oxide layer and a silicon oxide layer in order on at least one main surface of the transparent substrate in which $SiO_x$ in at least one silicon oxide layer in the multilayer film satisfies a relationship $1.55 \leq x < 2.00$, a luminous transmittance of the multilayer film is 20% to 89%, and a resistance value of the multilayer film is $10^4$ $\Omega$/sq or higher, and have completed the present invention, x in $SiO_x$ is a value determined by depth direction composition analysis in X-ray photoelectron spectroscopy (XPS) using argon ion sputtering. When the silicon oxide layer is an outermost layer, the value of x is determined excluding a point where a sputtering time is 0 minute.

ADVANTAGEOUS EFFECTS OF INVENTION

According to an aspect of the present invention, it is possible to provide a transparent substrate provided with a multilayer film, which has a light absorption ability, an insulating property, and excellent adhesiveness.

BRIEF DESCRIPTION OF DRAWINGS

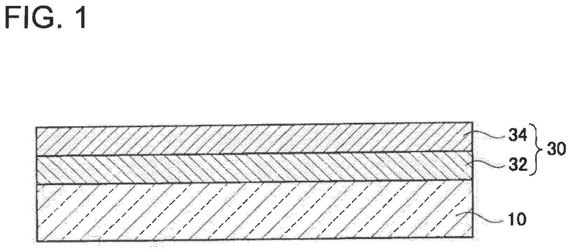

[FIG. 1] FIG. 1 is a cross-sectional view schematically showing a configuration example of a transparent substrate provided with a multilayer film.

DESCRIPTION OF EMBODIMENTS

Hereinafter, embodiments of the present invention are described in detail with reference to the drawings.

A transparent substrate provided with a multilayer film of the present invention includes a transparent substrate having two main surfaces, and a multilayer film obtained by laminating a metal oxide layer and a silicon oxide layer in order on at least one of the main surfaces of the transparent substrate. $SiO_x$ in the silicon oxide layer satisfies a relationship $1.55 \leq x < 2.00$. A luminous transmittance of the multilayer film is 20% to 89% and a resistance value of the multilayer film is $10^4$ $\Omega$/sq or higher.

The transparent substrate provided with a multilayer film according to the present invention includes the multilayer film obtained by laminating the metal oxide layer and the silicon oxide layer in order. $SiO_x$ in the silicon oxide layer satisfies the relationship $1.55 \leq x < 2.00$. From the viewpoint of adhesiveness and strength, $1.55 \leq x < 1.98$ is preferable, $1.55 \leq x < 1.88$ is more preferable, and $1.55 \leq x < 1.70$ is most preferable.

In an anti-reflection film having no light absorption property in the related art, a high-refractive-index layer is generally completely oxidized, and a silicon oxide layer as a low-refractive-index layer is also generally completely oxidized. Meanwhile, in the case of a high-refractive-index layer having a light absorption property as in the present invention, the high-refractive-index layer has a certain low degree of oxidation. Therefore, the present inventors presume that when the silicon oxide layer is completely oxidized, a mismatch in the degree of oxidation of the high-refractive-index layer occurs, which affects the adhesiveness. Meanwhile, it is presumed that when the degree of oxidation of the silicon oxide layer falls within the above range, electrons are transferred between the oxygen-deficient silicon oxide layer and the metal oxide layer, and the adhesiveness is improved. When x is 1.55 or more, the silicon oxide layer has a neutral color tone in visible light, so that the above range is preferable.

The above x is determined by depth direction composition analysis in X-ray photoelectron spectroscopy (XPS) in which argon ion sputtering is used.

In the transparent substrate provided with a multilayer film according to the present invention, a luminous transmittance of the multilayer film is 20% to 89%. When the luminous transmittance falls within the above range, the transparent substrate provided with a multilayer film has an appropriate light absorption ability. Therefore, when the transparent substrate provided with a multilayer film is used as a cover glass of an image display device, reflection from an interface between the cover glass and the multilayer film can be prevented. As a result, a bright-field contrast of the image display device is improved. The luminous transmittance can be measured by a method specified in JIS Z8709 (1999) as described in Examples described later. The luminous transmittance of the transparent substrate provided with a multilayer film according to the present invention is preferably 50% to 89%, and more preferably 65% to 85%.

In the transparent substrate provided with a multilayer film according to the present invention, a sheet resistance of the multilayer film is $10^4$ $\Omega$/sq or higher. When the sheet resistance of the multilayer film falls within the above range, the multilayer film is insulating. Therefore, even when a touch panel is provided in a case where the transparent substrate provided with a multilayer film is used as a cover glass of an image display device, a change in capacitance due to contact of a finger necessary for a capacitive touch sensor is maintained, and the touch panel can be made to function. The sheet resistance can be measured by a method specified in ASTM D257 or JIS K6271-6 (2008) as described in Examples described later. The sheet resistance of the multilayer film of the transparent substrate provided with a multilayer film according to the present invention is preferably $10^6$ $\Omega$/sq or higher, more preferably $10^8$ $\Omega$/sq or higher, and still more preferably $10^{11}$ $\Omega$/sq.

In the transparent substrate provided with a multilayer film according to the present invention, a luminous reflectance of the multilayer film is preferably 1% or less. When the luminous reflectance of the multilayer film falls within the above range, the effect of preventing external light from being reflected on the screen is high when the transparent substrate provided with a multilayer film is used as a cover glass of an image display device. The luminous reflectance can be measured by a method specified in JIS Z8701 (1999) as described in Examples described later. The luminous reflectance of the anti-reflection film of the transparent substrate provided with a multilayer film according to the present invention is more preferably 0.8% or less, and still more preferably 0.6% or less. The lower limit of the luminous reflectance is not particularly limited, but is preferably 0.05% or more, and more preferably 0.1% or more, for example.

In the transparent substrate provided with a multilayer film according to the present invention, a value b* in a transmission color of the multilayer film under a D65 light source is preferably 5 or less. When the value b* falls within the above range, transmitted light does not become yellowish, and therefore, the transparent substrate provided with a multilayer film is suitable for use as a cover glass of an image display device. The value b* in the transmission color under the D65 light source can be measured by a method specified in JIS Z8729 (2004) as described in Examples described later. The upper limit of the value b* of the transparent substrate provided with a multilayer film according to the present invention is more preferably 3 or less, and still more preferably 2 or less. The lower limit of the value b* is preferably -6 or more, and more preferably -4 or more. Within the above range, the transmitted light becomes colorless and does not interfere with transmitted light, which is preferable.

The transparent substrate according to the present invention is not particularly limited as long as the transparent substrate has excellent translucency. Examples thereof include glass and resin.

The multilayer film in the transparent substrate provided with a multilayer film according to one embodiment of the present invention preferably has the following configuration.

FIG. 1 is a cross-sectional view schematically showing a configuration example of the transparent substrate provided with a multilayer film. A multilayer film 30 is formed on a transparent substrate 10. The multilayer film 30 shown in FIG. 1 has a laminated structure in which two dielectric layers 32 and 34 having different refractive indices from each other are laminated. By laminating the dielectric layers 32 and 34 having different refractive indices from each other, reflection of light is prevented. The dielectric layer 32 is a high-refractive-index layer, and the dielectric layer 34 is a low-refractive-index layer.

In the multilayer film 30 shown in FIG. 1, the dielectric layer 32 is preferably formed of a mixed oxide of at least one selected from the group A consisting of Mo and W and at least one selected from the group B consisting of Si, Nb, Ti, Zr, Ta, Al, Sn, and In. In the mixed oxide, the content of the element of the group B contained in the mixed oxide (hereinafter, referred to as the content of the group B) is preferably less than 80 mass% with respect to the total of the element of the group A contained in the mixed oxide and the element of the group B contained in the mixed oxide.

The layer 34 is formed of $SiO_x$.

The layer 32 is preferably formed of a mixed oxide of at least one selected from the group A consisting of Mo and W and at least one selected from the group B consisting of Si, Nb, Ti, Zr, Ta, Al, Sn, and In. Among these, Mo is preferable for the group A, and Nb is preferable for the group B.

The use of the layer 34, which is an oxygen-deficient silicon oxide layer, and the layer 32 with Mo and Nb is preferable because the oxygen-deficient silicon oxide layer usually becomes yellowish in visible light, while the silicon oxide layer does not become yellowish even when oxygen is deficient by using Mo and Nb.

A refractive index of the layer 32 at a wavelength of 550 nm is preferably 1.8 to 2.3 from the viewpoint of the transmittance with the transparent substrate. An extinction coefficient of the layer 32 is preferably 0.005 to 3, and more preferably 0.04 to 0.38.

When the extinction coefficient is 0.005 or more, a desired absorption rate can be realized with an appropriate number of layers. Further, when the extinction coefficient is 3 or less, it is relatively easy to achieve both the reflection color and the transmittance.

The multilayer film 30 shown in FIG. 1 has a laminated structure in which two dielectric layers 32 and 34 are laminated, but the multilayer film in the present invention is not limited thereto, and may have a laminated structure in which three or more layers having different refractive indices from each other are laminated. In this case, it is not necessary that all the layers have different refractive indices. For example, in the case of a three-layer laminated structure, a three-layer laminated structure of a low-refractive-index layer, a high-refractive-index layer, and a low-refractive-index layer, or a three-layer laminated structure of a high-refractive-index layer, a low-refractive-index layer, and a high-refractive-index layer can be used. In the former case, the two low-refractive-index layers may have the same refractive index. In the latter case, the two high-refractive-index layers may have the same refractive index. In the case of a four-layer laminated structure, a four-layer laminated structure of a low-refractive-index layer, a high-refractive-index layer, a low-refractive-index layer, and a high-refractive-index layer, or a four-layer laminated structure of a high-refractive-index layer, a low-refractive-index layer, a high-refractive-index layer, and a low-refractive-index layer can be used. In this case, the two low-refractive-index layers may have the same refractive index and the two high-refractive-index layers may have the same refractive index.

There has been known a halftone mask used in the semiconductor manufacturing field as a light transmitting film having a light absorption ability and an insulating property. As the halftone mask, an oxygen-deficient film such as a $Mo-SiO_x$ film containing a small amount of Mo is used. In addition, as the light transmitting film having a light absorption ability and an insulating property, there is a narrow-bandgap film used in the field of semiconductor manufacturing.

However, since these films have a high light absorption ability on the short wavelength side of visible light, the transmitted light becomes yellowish. Therefore, these films are not suitable for a cover glass of an image display device.

In the present embodiment of the present invention, when the layer 32 in which the content of Mo is increased and the layer 34 formed of $SiO_x$ are provided, a transparent substrate provided with a multilayer film can be obtained which has a light absorption ability, an insulating property, and excellent adhesiveness and strength.

The transparent substrate provided with a multilayer film shown in FIG. 1 satisfies the characteristics of the transparent substrate provided with a multilayer film according to the present invention because the multilayer film 30 has the configuration described above.

When the content of the group B in the layer (A-B-O) 32 formed of a mixed oxide of an oxide of at least one selected from the group A consisting of Mo and W and an oxide of at least one selected from the group B consisting of Si, Nb, Ti, Zr, Ta, Al, Sn is less than 80 mass%, the value b* can be prevented from exceeding 5. The content of the group B is more preferably 70 mass% or less, and still more preferably 60 mass% or less.

In the case of a laminated structure in which three or more layers having different refractive indices from each other are laminated, a layer other than the layer (A-B-O) and the layer (SiOx) may be provided. In this case, it is necessary to select each layer so as to have a three-layer laminated structure of a low-refractive-index layer, a high-refractive-index layer, and a low-refractive-index layer, a three-layer laminated structure of a high-refractive-index layer, a low-refractive-index layer, and a high-refractive-index layer, a four-layer laminated structure of a low-refractive-index layer, a high-refractive-index layer, a low-refractive-index layer, and a high-refractive-index layer, or a four-layer laminated structure of a high-refractive-index layer, a low-refractive-index layer, a high-refractive-index layer, and a low-refractive-index layer, including the layer (A-B-O) and the layer (SiOx). The outermost layer is preferably the layer (SiOx). This is because when the outermost layer is the layer (SiOx), the outermost layer can be relatively easily produced in order to obtain low reflectivity. In the case of forming an anti-fouling film, it is preferable to form the anti-fouling film on the layer (SiOx) from the viewpoint of a bonding property related to durability of the anti-fouling film.

The layer (A-B-O) 32 is preferably amorphous. When the layer (A-B-O) 32 is amorphous, the layer (A-B-O) 32 can be formed at a relatively low temperature. When the transparent substrate is a resin, the resin is not damaged by heat and can be suitably applied.

In the configuration having the layer (A-B-O) 32 and the silicon oxide layer (SiOx) 34 on the transparent substrate 10, the metal of the group A in the layer 32 is Mo, the metal of the group B in the layer 32 is Nb, the layer (A-B-O) is represented by Mo(y)-Nb(z)-O, and the oxygen deficiency index of the layer 32 and the layer 34 is defined as follows.

$$\text{Oxygen deficiency index of layer } 32 = 2y + z - 1$$

$$\text{Oxygen deficiency index of layer } 34 = 2/x - 1$$

An absolute value of the Δ oxygen deficiency index is defined as the following formula (1).

$$\Delta \text{ Oxygen deficiency index } = |\text{Oxygen deficiency index of layer } 34 - \text{Oxygen deficiency index of layer } 32| = |2/x - 2y - z| \quad (1)$$

It is preferable that both the oxygen deficiency index of the layer 32 and the oxygen deficiency index of the layer 34 have positive values, and the absolute value of the Δ oxygen deficiency index is less than 0.46. By doing so, the oxygen deficiency indices of the silicon oxide layer (SiOx) 34 and the layer (A-B-O) 32 are relatively close to each other, and it is estimated that the adhesiveness is further improved. The absolute value of the Δ oxygen deficiency index is preferably less than 0.46 from the viewpoint of adhesiveness, more preferably 0.41 or less, still more preferably 0.36 or less, and most preferably 0.24 or less from the viewpoint of adhesiveness and strength.

The values of y and z are determined by depth direction composition analysis in X-ray photoelectron spectroscopy (XPS) in which argon ion sputtering is used. In the case where the metal oxide layer is the outermost layer, the values of y and z are determined excluding a point where the sputtering time is 0 minute.

When the oxygen deficiency indices of the layer 32 and the layer 34 are determined, the oxidation numbers of Mo and Nb in the layer 32 are +4 and +2, respectively, and the oxidation number of Si in the layer 34 is +4. In particular, the maximum oxidation numbers of Mo and Nb are +6 and +5, respectively, but empirically, there is a correspondence between the adhesiveness and the Δ oxygen deficiency index calculated by setting the oxidation numbers of Mo and Nb to +4 and +2, respectively. According to the literature (S. Hashimoto et al, Surf. Interface Anal. 18, 1992, 799-806), it is described that MoO₃ [VI] and Nb₂O₅ [V] are reduced during the depth direction analysis in XPS in which ion sputtering is used, and MoO₂ [IV], NbO [II], and SiO₂ [IV] are not reduced. Therefore, it is presumed that when the Δ oxygen deficiency index is calculated by setting the oxidation numbers of Mo, Nb, and Si to +4, +2, and +4, respectively, as the oxidation numbers of the metal oxides in a state of not being reduced at the time of analysis, a correspondence relationship with the adhesiveness appears.

Hereinafter, the transparent substrate provided with a multilayer film according to the present invention is further described.

\<Transparent Substrate\>

The transparent substrate is preferably formed of a material having a refractive index of 1.4 or more and 1.7 or less. This is because, when a display, a touch panel, or the like is optically bonded, reflection on a bonding surface can be sufficiently prevented.

The transparent substrate is preferably a glass substrate or a resin substrate.

As the glass substrate, glass having various compositions can be used. For example, the glass used in the present invention preferably contains sodium, and preferably has a composition that is formable and can be strengthened by a chemical strengthening treatment. Specific examples thereof include aluminosilicate glass, soda lime glass, borosilicate glass, lead glass, alkali barium glass, and aluminoborosilicate glass.

A thickness of the glass substrate is not particularly limited, but is usually preferably 5 mm or less, and more preferably 3 mm or less in order to effectively perform the chemical strengthening treatment.

The glass substrate is preferably a chemically strengthened glass which has been chemically strengthened in order to increase the strength of the cover glass. When an anti-glare treatment is applied to the glass substrate, the chemical strengthening is performed after the anti-glare treatment and before the multilayer film is formed.

It is preferable that the anti-glare treatment is applied to a main surface of the glass substrate on the side having the multilayer film. The anti-glare treatment method is not particularly limited, and a method in which a glass main surface is subjected to a surface treatment to form desired irregularities can be used. Specifically, a method of performing a chemical treatment on a main surface of a glass substrate, for example, a method of performing a frosting treatment is exemplified. In the frosting treatment, for example, a glass substrate as an object to be treated is immersed in a mixed solution of hydrogen fluoride and ammonium fluoride, and the immersed surface can be chemically surface-treated. In addition to these chemical treatments, physical treatments such as sandblasting, in which a crystalline silicon dioxide powder, a silicon carbide powder, or the like is blown onto the glass substrate surface with pressurized air, or polishing with a brush moistened with water and adhered with a crystalline silicon dioxide powder, a silicon carbide powder, or the like, can be used.

The resin substrate is preferably a resin film. Examples of the resin film include a thermoplastic resin and a thermosetting resin. Specific examples thereof include a polyvinyl chloride resin, a polyethylene resin, a polypropylene resin, a polystyrene resin, a polyvinyl acetate resin, a polyester resin, a polyurethane resin, a cellulose-based resin, an acrylic resin, an acrylonitrile-styrene (AS) resin, an acrylonitrile-butadiene-styrene (ABS) resin, a fluorine-based resin, a thermoplastic elastomer, a polyamide resin, a polyimide resin, a polyacetal resin, a polycarbonate resin, a modified polyphenylene ether resin, a polyethylene terephthalate resin, a polybutylene terephthalate resin, a polylactic acid-based resin, a cyclic polyolefin resin, and a polyphenylene sulfide resin. Among these, a cellulose-based resin is preferable, and a triacetyl cellulose resin, a polycarbonate resin, and a polyethylene terephthalate resin are more preferable. These resins may be used alone or in combination of two or more kinds thereof.

The thickness of the film is not particularly limited, but is preferably 20 $\mu$m to 150 $\mu$m, and more preferably 40 $\mu$m to 80 $\mu$m.

When a film is used as the transparent substrate 10, as one of the embodiments, a hard coat layer (not shown) may be disposed on the transparent substrate 10, and the multilayer film 30 may be provided thereon.

Further, as another embodiment, an anti-glare layer (not shown) may be disposed on the hard coat layer, and the multilayer film 30 may be provided thereon.

As the hard coat layer, dissolved polymer resin can be applied. The anti-glare layer increases haze by forming an uneven shape on one surface of the film, thereby imparting an anti-glare property. An anti-glare layer composition constituting the anti-glare layer is formed by dispersing at least a particulate substance having an anti-glare property in a solution in which a polymer resin as a binder is dissolved.

Examples of the particulate substance having an anti-glare property include inorganic fine particles such as silica, clay, talc, calcium carbonate, calcium sulfate, barium sulfate, aluminum silicate, titanium oxide, synthetic zeolite, alumina, and smectite, and organic fine particles formed of a styrene resin, a urethane resin, a benzoguanamine resin, a silicone resin, and an acrylic resin.

Examples of the polymer resin as a binder for the hard coat layer and the anti-glare layer include polymer resins formed of a polyester-based resin, an acrylic resin, an acrylic urethane-based resin, a polyester acrylate-based resin, a polyurethane acrylate-based resin, an epoxy acrylate-based resin, and a urethane-based resin.

\<Multilayer Film\>

The multilayer film described above can be formed on the main surface of the transparent substrate by using a known deposition method such as a sputtering method. That is, the dielectric layers or layers constituting the multilayer film are formed on the main surface of the transparent substrate by a known deposition method such as a sputtering method in accordance with order of lamination.

Examples of the sputtering method include magnetron sputtering, pulse sputtering, AC sputtering, and digital sputtering.

For example, a magnetron sputtering method is a method in which a magnet is installed on the back surface of a dielectric material serving as a base material to generate a magnetic field, and gas ion atoms collide with the surface of the dielectric material and are knocked out to form a sputtering film having a thickness of several nm. A continuous film of dielectric, which is an oxide or nitride of the dielectric material, can be formed.

For example, a digital sputtering method is a method of forming a thin film of a metal oxide by repeating, in the same chamber, a process of forming an extremely thin film of a metal first by sputtering and then oxidizing the extremely thin film by irradiation with oxygen plasma, oxygen ions, or oxygen radicals, unlike a normal magnetron sputtering method. In this case, since deposition molecules are metal when deposited on the substrate, it is presumed that the film is more ductile than when the film is deposited with a metal oxide. Therefore, it is considered that the rearrangement of the deposition molecules easily occurs even with the same energy, and as a result, a dense and smooth film can be formed.

<Anti-fouling Film>

From the viewpoint of protecting the outermost surface of the film, the transparent substrate provided with a multilayer film of the present invention may further have an anti-fouling film (also referred to as an "anti finger print (AFP) film") on the multilayer film. The anti-fouling film can be formed of, for example, a fluorine-containing organic silicon compound. The fluorine-containing organic silicon compound is not particularly limited as long as the fluorine-containing organic silicon compound can impart an antifouling property, water repellency, and oil repellency. Examples thereof include fluorine-containing organic silicon compounds having one or more groups selected from the group consisting of a polyfluoropolyether group, a polyfluoroalkylene group, and a polyfluoroalkyl group. The polyfluoropolyether group is a divalent group having a structure in which a polyfluoroalkylene group and an ethereal oxygen atom are alternately bonded.

As the commercially available fluorine-containing organic silicon compound having one or more groups selected from the group consisting of a polyfluoropolyether group, a polyfluoroalkylene group, and a polyfluoroalkyl group, KP-801 (trade name, manufactured by Shin-Etsu Chemical Co., Ltd.), KY178 (trade name, manufactured by Shin-Etsu Chemical Co., Ltd.), KY-130 (trade name, manufactured by Shin-Etsu Chemical Co., Ltd.), KY-185 (trade name, manufactured by Shin-Etsu Chemical Co., Ltd.), Optool (registered trademark) DSX, Optool AES (trade names, all manufactured by Daikin Industries, Ltd.), and the like can be preferably used.

The anti-fouling film is laminated on the anti-reflection film. When the anti-reflection film is deposited both main surfaces of the glass substrate or the resin substrate, the anti-fouling film may be deposited on both of the anti-reflection films, but the anti-fouling film may be laminated on only one of the surfaces. This is because the anti-fouling film only needs to be provided at a place where a hand of a person or the like may come into contact with the anti-fouling film. The anti-fouling film can be selected according to the use or the like.

The transparent substrate provided with a multilayer film of the present invention is suitable as a cover glass of an image display device, particularly as a cover glass of an image display device mounted on a vehicle or the like, such as an image display device of a navigation system mounted on a vehicle or the like.

EXAMPLES

Hereinafter, the present invention is described in detail with reference to Examples, but the present invention is not limited thereto. Examples 1, 2, 5, and 6 represent Working Examples, and Examples 3, 4, 7, and 8 represent Comparative Examples.

(Example 1)

By the following method, an anti-reflection film was formed on one main surface of a transparent substrate to produce a transparent substrate provided with an anti-reflection film.

First, by digital sputtering, a target obtained by mixing and sintering niobium and molybdenum at a weight ratio of 40 : 60 was used, while maintaining the pressure at 0.3 Pa, an oxide film was deposited by repeating, at a high speed, deposition of a metal film having a fine film thickness with argon gas, and oxidation with oxygen gas performed immediately thereafter, and a Mo-Nb-O layer having a thickness of 10 nm was thus deposited on one main surface of glass (aluminosilicate glass, thickness: 1.1 mm), as a dielectric layer (1) (metal oxide layer).

Next, by the same digital sputtering, a silicon target was used, while maintaining the pressure at 0.3 Pa, a silicon oxide film was deposited by repeating, at a high speed, deposition of a silicon film with argon gas, and oxidation with oxygen gas performed immediately thereafter, and a layer of silicon oxide [silica ($SiO_x$)] having a thickness of 40 nm was thus deposited over the Mo-Nb-O layer, as a dielectric layer (2) (silicon oxide layer). Here, an oxygen flow rate at the time of oxidation with oxygen gas was 400 sccm. An input power of the oxidation source was 0 W.

Next, by the same digital sputtering, a target obtained by mixing and sintering niobium and molybdenum at a weight ratio of 40 : 60 was used, while maintaining the pressure at 0.3 Pa, an oxide film was deposited by repeating, at a high speed, deposition of a metal film having a fine film thickness with argon gas, and oxidation with oxygen gas performed immediately thereafter, and a Mo-Nb-O layer having a thickness of 120 nm was thus deposited over the silicon oxide layer, as a dielectric layer (3) (metal oxide layer).

Subsequently, by the same digital sputtering, a silicon target was used, while maintaining the pressure at 0.3 Pa, a silicon oxide film was deposited by repeating, at a high speed, deposition of a silicon film with argon gas, and oxidation with oxygen gas performed immediately thereafter, and a layer of silicon oxide [silica ($SiO_x$)] having a thickness of 82 nm was thus deposited over the Mo-Nb-O layer, as a dielectric layer (4) (silicon oxide layer). Here, an oxygen flow rate at the time of oxidation with oxygen gas was 400 sccm. An input power of the oxidation source was 0 W.

In ordinary digital sputtering, oxidation is promoted by applying electric power to oxygen gas to turn the oxygen gas into plasma or radical and irradiating the metal film with the plasma or radical. However, as in the present embodiment, the degree of oxidation can be intentionally prevented by not applying electric power. The structure is shown in Table 1.

The anti-reflection film thus obtained was subjected to depth direction composition analysis in X-ray photoelectron spectroscopy (XPS) in which argon ion sputtering is used. The conditions of depth direction composition analysis in XPS were as follows.

Apparatus: Quantera-SXM manufactured by Ulvac-Phi, Inc.
XPS conditions:

- X-ray: monochromatized AlK$\alpha$ ray
- Detection angle: 45° with respect to sample surface
- Path energy: 224 eV
- Energy step: 0.4 eV/step
- Monitor peak: Si2p, Mo3d, Nb3d, Ols

Sputtering conditions:

- Sputter ion gun: Ar$^+$
- Acceleration voltage: 4 kV
- Raster: $3 \times 3$ mm$^2$
- Sputtering rate: 8.71 nm/min (in terms of $SiO_2$ film)

Analysis software: Multi Pak Version 9.3.0.3 manufactured by Ulvac-Phi, Inc.

Method of removing peak background: Shirley method

By depth direction composition analysis in XPS, a depth profile was obtained with a horizontal axis representing a sputtering time (minutes) and a vertical axis representing an atomic concentration (atomic%). An atomic concentration ratio (atomic ratio) of O to Si was determined from the depth profiles of Si2p and Ols of the dielectric layer (4), and x of the $SiO_x$ layer was calculated. A point where the sputtering time is 0 minute is the outermost surface, and the reliability of the value of x decreases due to the influence of surface contamination or the like. In addition, in the vicinity of the interface between the dielectric layer (4) and the dielectric layer (3), the reliability of the value of x decreases due to the influence of the dielectric layer (3). Therefore, the value of x at the point where the sputtering time was 0 minute was excluded, and an average value of the values of x in the depth region where the photoelectron intensities of a Mo3d peak and a Nb3d peak were not detected was obtained, and the average value was defined as x of the $SiO_x$ layer.

In addition, from the depth profiles of Nb3d, Mo3d, and Ols of the dielectric layer (3), atomic concentration ratios of Nb and Mo to O, that is, y and z of Mo(y)-Nb(z)-O were determined. In the vicinity of the interface between the dielectric layer (4) and the dielectric layer (3) and in the vicinity of the interface between the dielectric layer (3) and the dielectric layer (2), the reliability of the values of y and z decreases due to the influence of the $SiO_x$ layer. Therefore, the average values of the values of y and z of Mo(y)-Nb(z)-O was determined from the depth region where the photoelectron intensity of a Si2p peak was not detected, and the average values were defined as y and z of Mo(y)-Nb(z)-O.

A default corrected relative sensitivity factor (corrected RSF) given by the analysis software was used to calculate the atomic concentration. Corrected RSFs of Si2p, Mo3d, Nb3d, and Ols were 94.999 (Si2p), 894.834 (Mo3d), 790.312 (Nb3d), and 163.432 (Ols), respectively.

As a result of XPS analysis, when an atomic weight of Mo was 95.96 (g/mol) and an atomic weight of Nb was 92.91 (g/mol), a composition ratio (wt%) of Mo and Nb in the Mo-Nb-O layer of the dielectric layer (3) was estimated to be Mo : Nb = 68 : 32 (wt%). These Mo-Nb-O layers had a refractive index of 2.1 at 550 nm and an extinction coefficient of 0.04.

(Example 2)

Deposition was performed in the same manner as in Example 1 except that an oxygen gas flow rate at the time of depositing a silicon oxide layer was changed to 200 sccm. The evaluation results of the obtained transparent substrate provided with a multilayer film are shown in the following Table 1. As a result of XPS analysis, a composition ratio of Mo and Nb in a Mo-Nb-O layer of the dielectric layer (3) was estimated in the same manner as in Example 1 to be Mo : Nb = 69 : 31 (wt%).

(Example 3)

Deposition was performed in the same manner as in Example 1 except that an input power of an oxidation source at the time of depositing a silicon oxide layer was changed to 350 W. The evaluation results of the obtained transparent substrate provided with a multilayer film are shown in the following Table 1. As a result of XPS analysis, a composition ratio of Mo and Nb in a Mo-Nb-O layer of the dielectric layer (3) was estimated in the same manner as in Example 1 to be Mo : Nb = 68 : 32 (wt%).

(Example 4)

Deposition was performed in the same manner as in Example 1 except that an input power of an oxidation source at the time of depositing a silicon oxide layer was changed to 200 W. The evaluation results of the obtained transparent substrate provided with a multilayer film are shown in the following Table 1. As a result of XPS analysis, a composition ratio of Mo and Nb in a Mo-Nb-O layer of the dielectric layer (3) was estimated in the same manner as in Example 1 to be Mo : Nb = 69 : 31 (wt%).

(Example 5)

Deposition was performed in the same manner as in Example 1 except that the glass was changed to a triacetyl cellulose resin (thickness: 40 μm). The evaluation results of the obtained transparent substrate provided with a multilayer film are shown in the following Table 2. As a result of XPS analysis, a composition ratio of Mo and Nb in a Mo-Nb-O layer of the dielectric layer (3) was estimated in the same manner as in Example 1 to be Mo : Nb = 68 : 32 (wt%).

(Example 6)

Deposition was performed in the same manner as in Example 5 except that an oxygen gas flow rate at the time of depositing a silicon oxide layer was changed to 200 sccm. The evaluation results of the obtained transparent substrate provided with a multilayer film are shown in the following Table 2. As a result of XPS analysis, a composition ratio of Mo and Nb in a Mo-Nb-O layer of the dielectric layer (3) was estimated in the same manner as in Example 1 to be Mo : Nb = 68 : 32 (wt%).

(Example 7)

Deposition was performed in the same manner as in Example 5 except that an input power of an oxidation source at the time of depositing a silicon oxide layer was changed to 350 W. The evaluation results of the obtained transparent substrate provided with a multilayer film are shown in the following Table 2. As a result of XPS analysis, a composition ratio of Mo and Nb in a Mo-Nb-O layer of the dielectric layer (3) was estimated in the same manner as in Example 1 to be Mo : Nb = 68 : 32 (wt%).

(Example 8)

Deposition was performed in the same manner as in Example 5 except that an input power of an oxidation source at the time of depositing a silicon oxide layer was changed to 200 W. The evaluation results of the obtained transparent substrate provided with a multilayer film are shown in the following Table 2. As a result of XPS analysis, a composition ratio of Mo and Nb in a Mo-Nb-O layer of the dielectric layer (3) was estimated in the same manner as in Example 1 to be Mo : Nb = 68 : 32 (wt%). A temperature during deposition was about 60°C to 90°C, and no particular change was observed in the resin substrate.

When the anti-reflection film having the laminated structure was analyzed by an X-ray structure analyzer (XRD), no crystal peak was observed, and it was confirmed that the anti-reflection film was amorphous.

The following evaluation results of the prepared transparent substrate provided with a multilayer film are shown in Tables 1 and 2 below.

<Sheet Resistance of Anti-reflection Film>

A sheet resistance value was measured using a measuring device [manufactured by Mitsubishi Chemical Analytech Co., Ltd., device name: Hiresta UP (MCP-HT450 type)]. A probe was placed on a center of the transparent substrate provided with an anti-reflection film, and the measurement was performed by applying a current at 10 V for 10 seconds.

<Luminous Transmittance of Transparent Substrate Provided with Anti-reflection Film>

The spectral transmittance was measured by a spectrophotometer (manufactured by Shimadzu Corporation, trade name: SolidSpec-3700), and the luminous transmittance (stimulus value Y defined in JIS Z8701: 1999) was determined by calculation.

<Adhesiveness>

A film is linearly scratched with a cutter knife, and a cotton cloth impregnated with ethanol is reciprocated and rubbed on the scratch to confirm whether peeling of the film occurs around the scratch. A load was set to 12 N, and rubbing was performed 100 times. The evaluation was performed by the above method, and the evaluation was performed according to the following criteria.

A: No peeling was observed in both visual observation and microscope.
B: Peeling was not visually observed, but allowable peeling was slightly observed with a microscope.
C: When visually confirmed, film peeling occurred.

<Luminous Reflectance of Anti-reflection Film>

The spectral reflectance was measured by a spectrophotometer (manufactured by Shimadzu Corporation, trade name: SolidSpec-3700), and the luminous reflectance (stimulus value Y of reflection defined in JIS Z8701: 1999) was determined by calculation. The back surface side (glass substrate side) of the transparent substrate provided with an anti-reflection film was blackened with a lacquer, and the measurement was performed in a state in which the back surface reflection was eliminated.

<Transmission Color of Transparent Substrate Provided with Anti-reflection Film under D65 Light Source (value b*)>

A color index (value b*) specified in JIS Z8729: 2004 was determined from a transmission spectrum obtained by measuring the spectral transmittance. A D65 light source was used as a light source.

[Table 1]

| | | Example 1 | Example 2 | Example 3 | Example 4 |
|---|---|---|---|---|---|
| Structure | Transparent substrate | Glass | Glass | Glass | Glass |
| | Dielectric layer (1) | Mo-Nb-O [10 nm] | Mo-Nb-O [10 nm] | Mo-Nb-O [10 nm] | Mo-Nb-O [10 nm] |
| | Dielectric layer (2) | $SiO_x$ [40 nm] | $SiO_x$ [40 nm] | $SiO_x$ [40 nm] | $SiO_x$ [40 nm] |
| | Dielectric layer (3) | Mo-Nb-O [120 nm] | Mo-Nb-O [120 nm] | Mo-Nb-O [120 nm] | Mo-Nb-O [120 nm] |
| | Dielectric layer (4) | $SiO_x$ [82 nm] | $SiO_x$ [82 nm] | $SiO_x$ [82 nm] | $SiO_x$ [82 nm] |

(continued)

| | | Example 1 | Example 2 | Example 3 | Example 4 |
|---|---|---|---|---|---|
| Content of group B in dielectric layer (3) (mass%) | | 32 | 31 | 32 | 31 |
| Value of x in $SiO_x$ | | 1.97 | 1.69 | 2.20 | 2.10 |
| Value of y in Mo(y)-Nb(z)-O of dielectric layer (3) | | 0.57 | 0.57 | 0.56 | 0.58 |
| Value of z in Mo(y)-Nb(z)-O of dielectric layer (3) | | 0.28 | 0.27 | 0.27 | 0.27 |
| $\Delta$ oxygen deficiency index $\lvert 2/x - 2y - z\rvert$ | | 0.40 | 0.23 | 0.48 | 0.48 |
| Luminous transmittance (%) | | 69.2 | 65.8 | 70.1 | 72.9 |
| Sheet resistance value ($\Omega$/sq) | | $1.2 \times 10^9$ | $1.5 \times 10^9$ | $1.2 \times 10^9$ | $1.1 \times 10^9$ |
| Adhesiveness | | B | A | C | C |
| Luminous reflectance (%) | | 0.22 | 0.2 4 | 0.19 | 0.22 |
| Transmission color b* | | 0.79 | 1.31 | 0.37 | -0.07 |
| Extinction coefficient | | 0.04 | 0.04 | 0.04 | 0.04 |

[Table 2]

| | | Example 5 | Example 6 | Example 7 | Example 8 |
|---|---|---|---|---|---|
| Structure | Transparent substrate | Triacetyl cellulosic resin | Triacetyl cellulosic resin | Triacetyl cellulosic resin | Triacetyl cellulosic resin |
| | Dielectric layer (1) | Mo-Nb-O [10 nm] | Mo-Nb-O [10 nm] | Mo-Nb-O [10 nm] | Mo-Nb-O [10 nm] |
| | Dielectric layer (2) | $SiO_x$ [40 nm] | $SiO_x$ [40 nm] | $SiO_x$ [40 nm] | $SiO_x$ [40 nm] |
| | Dielectric layer (3) | Mo-Nb-O [120 nm] | Mo-Nb-O 1120 nm] | Mo-Nb-O [120 nm] | Mo-Nb-O [120 nm] |
| | Dielectric layer (4) | $SiO_x$ [82 nm] | $SiO_x$ [82 nm] | $SiO_x$ [82 nm] | $SiO_x$ [82 nm] |
| Content of group B in dielectric layer (3) (mass%) | | 32 | 32 | 32 | 32 |
| Value of x in SiOx | | 1.88 | 1.62 | 2.25 | 2.08 |
| Value of y in Mo(y)-Nb(z)-O of dielectric layer (3) | | 0.57 | 0.58 | 0.55 | 0.57 |
| Value of z in Mo(y)-Nb(z)-O of dielectric layer (3) | | 0.28 | 0.28 | 0.27 | 0.28 |
| $\Delta$ oxygen deficiency index $\lvert 2/x - 2y - z\rvert$ | | 0.36 | 0.21 | 0.48 | 0.46 |
| Luminous transmittance (%) | | 70.2 | 66.5 | 71.5 | 73.9 |
| Sheet resistance value ($\Omega$/sq) | | $1.3 \times 10^9$ | $1.5 \times 10^9$ | $1.6 \times 10^9$ | $1.4 \times 10^9$ |
| Adhesiveness | | B | A | C | C |
| Luminous reflectance (%) | | 0.25 | 0.26 | 0.20 | 0.24 |
| Transmission color b* | | 0.75 | 1.18 | 0.36 | -0.07 |

(continued)

|  |  | Example 5 | Example 6 | Example 7 | Example 8 |
|---|---|---|---|---|---|
| Extinction coefficient |  | 0.04 | 0.04 | 0.04 | 0.04 |

As shown in Tables 1 and 2, in the transparent substrates provided with multilayer films of Examples 1, 2, 5, and 6, the silicon oxide layer $SiO_x$ satisfies a relationship $1.55 \leq x < 2.00$, so that these transparent substrates provided with multilayer films had high adhesiveness. Further, the luminous transmittance of the multilayer film was 20% to 89%, so that these transparent substrates provided with multilayer films had a light absorption ability. The sheet resistance of the multilayer film was $10^4$ $\Omega$/sq or higher, so that these transparent substrates provided with multilayer films had an insulating property. Meanwhile, the transparent substrates provided with multilayer films of Examples 3, 4, 7, and 8 in which the silicon oxide layer $SiO_x$ satisfies a relationship $x \geq 2.00$ had low adhesiveness.

In Tables 1 and 2, the transparent substrates provided with multilayer films of Examples 1, 2, 5, and 6 in which a value of the $\Delta$ oxygen deficiency index $|2/x - 2y - z|$ was less than 0.46 had higher adhesiveness than that of Examples 3, 4, 7, and 8.

Although the present invention has been described in detail with reference to specific examples, it is apparent to those skilled in the art that it is possible to add various alterations and modifications without departing from the spirit and the scope of the present invention. This application is based on a Japanese patent application filed on December 18, 2019 (Application No. 2019-228161), the entire contents thereof being incorporated herein by reference. In addition, all references cited here are entirely incorporated.

REFERENCE SIGNS LIST

10 Transparent substrate
30 Multilayer film
32, 34 Dielectric layer

**Claims**

1. A transparent substrate provided with a multilayer film, comprising: a transparent substrate having two main surfaces; and a multilayer film obtained by laminating a metal oxide layer and a silicon oxide layer in order on at least one of the main surfaces of the transparent substrate,

   wherein $SiO_x$ in at least one silicon oxide layer in the multilayer film satisfies a relationship $1.55 \leq x < 2.00$, and the multilayer film has a luminous transmittance of 20% to 89% and a resistance value of $10^4$ $\Omega$/sq or higher, provided that x in $SiO_x$ is a value determined by depth direction composition analysis in X-ray photoelectron spectroscopy (XPS) using argon ion sputtering, and when the silicon oxide layer is an outermost layer, the value of x is determined excluding a point where a sputtering time is 0 minute.

2. The transparent substrate provided with a multilayer film according to claim 1, wherein the multilayer film has a luminous reflectance of 1% or less.

3. The transparent substrate provided with a multilayer film according to claim 1 or 2, wherein a value b* in a transmission color of the multilayer film under a D65 light source is 5 or less.

4. The transparent substrate provided with a multilayer film according to any one of claims 1 to 3,

   wherein the multilayer film has a laminated structure in which at least two layers having different refractive indices from each other are laminated,
   at least one layer of the laminated structure is mainly formed of an oxide of Si,
   another at least one layer of the laminated structure is mainly formed of a mixed oxide of an oxide of at least one selected from the group A consisting of Mo and W and an
   oxide of at least one selected from the group B consisting of Si, Nb, Ti, Zr, Ta, Al, Sn, and In, and
   a content of an element of the group B contained in the mixed oxide is less than 80 mass% with respect to a total of an element of the group A contained in the mixed oxide and the element of the group B contained in the mixed oxide.

5. The transparent substrate provided with a multilayer film according to claim 4,

wherein when a composition of the layer containing the element of the group A and the element of the group B, which is determined by depth direction composition analysis in X-ray photoelectron spectroscopy (XPS) using argon ion sputtering, is A(y)-B(z)-O, A is Mo, and B is Nb,
an absolute value between an oxygen deficiency index of the metal oxide layer and an oxygen deficiency index of the silicon oxide layer satisfies the following formula (1):

$$|2/x - 2y - z| < 0.46 \quad (1),$$

provided that in the formula (1), the oxygen deficiency index of the metal oxide layer is 2y + z - 1, the oxygen deficiency index of the silicon oxide layer is 2/x - 1, x represents a value of x of at least one silicon oxide layer $SiO_x$ in contact with the metal oxide layer, and both the oxygen deficiency index of the metal oxide layer and the oxygen deficiency index of the silicon oxide layer take positive values, and
in the case where the metal oxide layer is an outermost layer, the values of y and z are determined excluding a point where the sputtering time is 0 minute.

6. The transparent substrate provided with a multilayer film according to any one of claims 1 to 5, further comprising an anti-fouling film on the multilayer film.

7. The transparent substrate provided with a multilayer film according to any one of claims 1 to 6, wherein the transparent substrate is a glass substrate.

8. The transparent substrate provided with a multilayer film according to claim 7, wherein the glass substrate is chemically strengthened.

9. The transparent substrate provided with a multilayer film according to claim 7 or 8, wherein an anti-glare treatment is applied to the main surface of the glass substrate on a side having the multilayer film.

10. The transparent substrate provided with a multilayer film according to any one of claims 1 to 6, wherein the transparent substrate is a resin substrate.

11. The transparent substrate provided with a multilayer film according to claim 10, wherein an anti-glare treatment is applied to the main surface of the resin substrate on a side having the multilayer film.

12. An image display device comprising the transparent substrate provided with a multilayer film according to any one of claims 1 to 11.

FIG. 1

## INTERNATIONAL SEARCH REPORT

| International application No. |
| --- |
| PCT/JP2020/046418 |

### A. CLASSIFICATION OF SUBJECT MATTER
B32B 9/00(2006.01)i; C03C 17/34(2006.01)i; C03C 17/42(2006.01)i
FI: B32B9/00A; C03C17/34 Z; C03C17/42

According to International Patent Classification (IPC) or to both national classification and IPC

### B. FIELDS SEARCHED

Minimum documentation searched (classification system followed by classification symbols)
B32B1/00-43/00, C03C15/00-23/00, C23C14/00-14/58, G02B1/10-1/18, G02B5/00-5/136

Documentation searched other than minimum documentation to the extent that such documents are included in the fields searched
| | |
| --- | --- |
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)
JSTPlus/JMEDPlus/JST7580 (JDreamIII)

### C. DOCUMENTS CONSIDERED TO BE RELEVANT

| Category* | Citation of document, with indication, where appropriate, of the relevant passages | Relevant to claim No. |
| --- | --- | --- |
| Y | JP 2018-115105 A (ASAHI GLASS CO., LTD.) 26 July 2018 (2018-07-26) claims, paragraphs [0013], [0019]-[0021], [0044], examples | 1-12 |
| Y | JP 2002-321302 A (ZEON CORP.) 05 November 2002 (2002-11-05) claims, paragraphs [0008], [0029], [0036], [0042], examples | 1-12 |
| Y | JP 2019-152686 A (DAINIPPON PRINTING CO., LTD.) 12 September 2019 (2019-09-12) paragraph [0085] | 1-12 |
| Y | WO 2019/176552 A1 (JX NIPPON MINING & METALS CORPORATION) 19 September 2019 (2019-09-19) claims, paragraph [0009], examples | 5 |

☒ Further documents are listed in the continuation of Box C.   ☒ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 03 February 2021 (03.02.2021) | 16 February 2021 (16.02.2021) |

| Name and mailing address of the ISA/ | Authorized officer |
| --- | --- |
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

INTERNATIONAL SEARCH REPORT

| | International application No. |
|---|---|
| | PCT/JP2020/046418 |

C (Continuation).  DOCUMENTS CONSIDERED TO BE RELEVANT

| Category* | Citation of document, with indication, where appropriate, of the relevant passages | Relevant to claim No. |
|---|---|---|
| A | JP 2000-241605 A (SONY CORP.) 08 September 2000 (2000-09-08) | 1-12 |

Form PCT/ISA/210 (continuation of second sheet) (January 2015)

INTERNATIONAL SEARCH REPORT

Information on patent family members

International application No.

PCT/JP2020/046418

| Patent Documents referred in the Report | Publication Date | Patent Family | Publication Date |
|---|---|---|---|
| JP 2018-115105 A | 26 Jul. 2018 | US 2018/0203354 A1 claims, paragraphs [0017], [0024]-[0026], [0073], [0092], examples CN 108312655 A | |
| JP 2002-321302 A | 05 Nov. 2002 | US 2004/0114067 A1 claims, paragraphs [0013], [0068], [0085], examples EP 1357405 A1 CN 1489711 A KR 10-2003-0075153 A | |
| JP 2019-152686 A | 12 Sep. 2019 | (Family: none) | |
| WO 2019/176552 A1 | 19 Sep. 2019 | KR 10-2019-0120272 A CN 110637102 A TW 201938823 A | |
| JP 2000-241605 A | 08 Sep. 2000 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018115105 A
- JP 2016068470 A
- JP 2019228161 A

**Non-patent literature cited in the description**

- **S. HASHIMOTO et al.** *Surf. Interface Anal.,* 1992, vol. 18, 799-806